# EUROPÄISCHE PATENTSCHRIFT

(11) **EP 1 665 287 B1**
(45) Veröffentlichungstag und Bekanntmachung des Hinweises auf die Patenterteilung: **11.07.2007**
(21) Anmeldenummer: 04766488.3
(22) Anmeldetag: 12.08.2004
(51) Int. Cl.: G11C 29/00

(54) **VERWALTUNG DEFEKTER BL CKE IN FLASH-SPEICHERN**
MANAGEMENT OF DEFECTIVE BLOCKS IN FLASH MEMORIES
GESTION DE BLOCS DEFECTUEUX DANS DES MEMOIRES FLASH

(30) Priorität: 10.09.2003 DE 10341616
(43) Veröffentlichungstag der Anmeldung: 07.06.2006
(73) Patentinhaber: Hyperstone AG, 78467 Konstanz (DE)
(72) Erfinder: KÜHNE, Reinhard, 78479 Reichenau (DE)
(74) Vertreter: Hanewinkel, Lorenz
(86) Internationale Anmeldenummer: PCT/EP2004/051785
(87) Internationale Veröffentlichungsnummer: WO 2005/027139

(56) Entgegenhaltungen:
- US-A- 5 841 699
- US-B1- 6 591 329

## Beschreibung

Die Erfindung bezieht sich auf ein Verfahren zur Verwaltung von defekten Speicherblöcken in einem nichtflüchtigen Speichersystem mit einzeln löschbaren, mit realen Speicherblockadressen adressierbaren Speicherblöcken, und die durch eine Adressumsetzung mittels einer Zuordnertabelle von logischen Blockadressen in jeweils eine der realen Speicherblockadressen adressierbar sind.

Flash-Speicher werden in vielen Computersystemen eingesetzt, insbesondere auch in wechselbaren Speicherkarten für digitale Kameras und tragbare Computer. Flash-Speicher sind in Speicherblöcken mit jeweils vielen Sektoren organisiert. Wesentliche Eigenschaften dieser Speicher sind, dass nur eine beschränkte Anzahl von Schreib- und Löschoperationen möglich ist und dass das Löschen nur in großen Speicherblöcken möglich ist. Dabei beanspruchen die Schreib- und Löschvorgänge sehr viel mehr Zeit (bis zum Faktor 50) als das Lesen. Durch viele Schreib- und Löschvorgänge nutzen sich die Speicherblöcke ab und lassen sich dann nicht mehr sicher Schreiben oder Löschen. Durch "wear leveling", wie etwa in der Patentanmeldung PCT/EP98/08516 beschrieben, wird eine in etwa gleiche Anzahl von Löschvorgängen für alle Speicherblöcke erreicht. Da durch moderne Produktionstechniken die Güte und damit die Löschhäufigkeit für alle Speicherzellen ähnlich ist, können Verwaltungsverfahren eingesetzt werden, die für alle Speicherblöcke gleich sind.

Bei bekannten Verfahren, z.B. nach der Patentanmeldung EP 0,617,363 wird bei Erkennen eines defekten Blockes dieser durch einen Reserveblock ersetzt und die beiden miteinander in einer Tabelle verkettet. Außerdem wird eine Tabelle über defekte Speicherzellen geführt. Solche Verfahren führen zum längeren Durchsuchen von Tabellen, um den gültigen Speicherblock zu einer Speicheroperation zu finden.
In dem Patent US 5,841,699 ist ein Speichersystem beschrieben, bei dem neben einer Adressumsetzungstabelle von logischen in physikalische Adressen noch eine zweite Tabelle gepflegt wird, in der Statusinformationen zu den physikalischen Blöcken gespeichert sind. Dabei ist die eine Tabelle im flüchtigen Speicher und die zweite Tabelle in einem nichtflüchtigen Speicher gehalten, was einen besondere Verwaltungsaufwand bedeutet.
In dem Patent US 6,591,329 ist ebenfalls ein Speichersystem mit zwei Tabellen beschrieben. Neben der Adresstabelle wird die Tabelle mit den Statusinformationen gepflegt. Beide Tabellen sind im flüchtigen Speicher gehalten und es wird das Verfahren zur Rekonstruktion der Tabellen nach einem Reset beschrieben.

Es ist Aufgabe der Erfindung alle Speicherblöcke in einer Zuordnertabelle zu verwalten und diese so zu organisieren, dass defekte Speicherblöcke nicht mehr in Speicheroperationen einbezogen werden.

Gelöst wird diese Aufgabe dadurch, dass die Zuordnertabelle mindestens in einen Nutzdatenbereich, einen Bufferblockbereich, einen Defektbereich und in einen Reservebereich gegliedert ist, und dass nach einem Fehler beim Löschen eines Blockes die Zuordnertabelle so geändert wird, dass die Speicherblockadresse des entsprechenden Blockes in den Defektbereich eingetragen und an seiner Stelle ein Block adressiert wird, der zuvor im Reservebereich eingetragen war.

Vorteilhafte Ausgestaltungen der Erfindung sind in den Unteransprüchen angegeben.

Das hier betrachtete Speichersystem mit nichtflüchtigen Speicherzellen ist in Speicherblöcken organisiert, die über eine Löschoperation einzeln löschbar sind.
Die Speicherblöcke werden über ihre Speicherblockadresse angesprochen. Von einem Hostsystem vorgegebene logische Blockadressen werden mittels einer Zuordnertabelle in Speicherblockadressen gewandelt. Dabei sind die logischen Blockadressen kontinuierlich vergeben. Die logische Blockadresse dient als Index in die Zuordnertabelle, in der zu jeder logischen Adresse eine Speicherblockadresse eingetragen ist, die im Betrieb mit anderen Speicherblockadressen ausgetauscht werden kann. Außerdem werden in der Tabelle Merker zu jedem Speicherblock mitgeführt.
Die Zuordnertabelle ist in mindestens vier Bereiche aufgeteilt: einen Nutzdatenbereich, einen Bufferblockbereich, einen Reservebereich und einen Defektbereich, die direkt aneinander anschließen. Dabei ist der Nutzdatenbereich der bei weitem größte Bereich. Eine Aufteilung könnte beispielsweise bei einem Speichersystem mit 1000 Speicherblöcken folgendermaßen gestaltet sein: 944 Nutzdatenblöcke, 4 Bufferblöcke, zuerst 52 Reserveblöcke und 2 Defektblöcke.
Tritt nun beim Löschen ein Fehler auf, wird in der Zuordnertabelle der Eintrag des Speicherblocks mit einem Reserveblock vertauscht und seine Adresse in den Defektbereich eingetragen.

Der Defektbereich ist vorteilhafterweise jeweils nur so groß, wie bisher defekte Blöcke angefallen sind. Wird ein neuer defekter Block erkannt, wird der Defektbereich um einen Eintrag vergrößert und der Reservebereich um einen Eintrag verkleinert. Die Gesamtgröße des Reserve- plus Defektbereiches bleibt konstant und es sind keine weiteren Tabellenveränderungen notwendig.

Da alle Speicherzellen in etwa die gleiche Defektwahrscheinlichkeit besitzen, und vorteilhafterweise die Löschhäufigkeit durch "wear leveling" aller Speicherblöcke angeglichen wird, gibt das Verhältnis zwischen Defekt- und Reserveblöcken die Güte und die Gesamtabnutzung des Speichersystems an, was einfach ausgewertet werden kann.

Wird beim Schreiben in einen Speicherblock ein Fehler erkannt, wird er mit dem Merker "defect" gekennzeichnet. Da bei einem solchen Fehler nur wenige Bits verkehrt sind, werden beim Lesen dieses Blockes die Bitfehler mittels der Prüfbytes korrigiert und der richtige Inhalt wiedergegeben. Erst beim nächsten Schreiben des als "defect" gekennzeichneten Speicherblocks wird dieser vorher mit einem anderen Speicherblock aus dem Bufferbereich getauscht.

Das Löschen von genutzten und nicht mehr aktuellen Speicherblöcken wird vorteilhafterweise durch ein Hintergrundprogramm erledigt, das entsprechende Merker zu den Speicherblöcken auswertet. Trifft dieses Programm auf einen Speicherblock der mit dem Merker "defect" gekennzeichnet ist, wird dieser nicht gelöscht, sondern direkt mit einem Reserveblock getauscht. In Zukunft wird der defekte Block nicht mehr verwendet.

Eine vorteilhafte Ausführung der Erfindung ist beispielhaft in den Figuren beschrieben.
Fig. 1 zeigt den Aufbau der Zuordnertabelle zu den Speicherblöcken bei Auftreten eines Defektes
Fig. 2 zeigt die Zuordnertabelle nach Bereinigung aufgrund eines Schreibfehlers

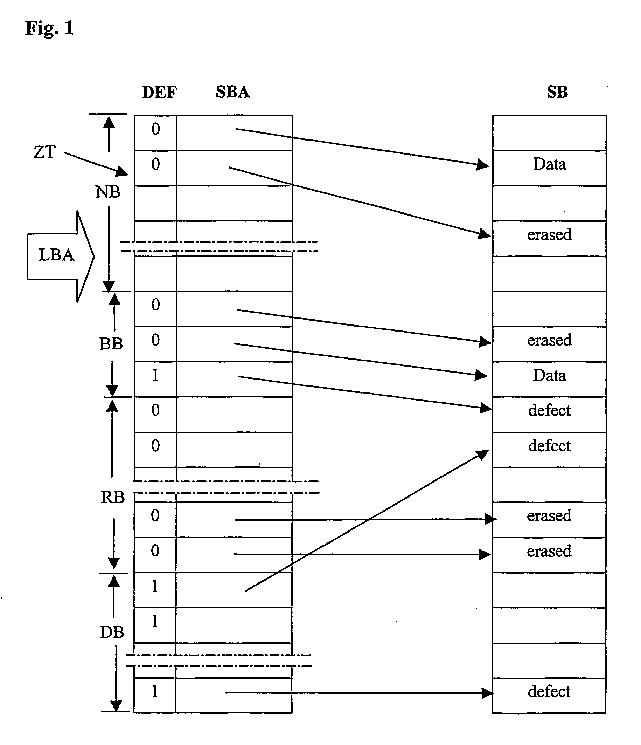

In Fig. 1 ist die Zuordnertabelle ZT dargestellt, die in vier Bereiche aufgeteilt ist. Der erste Bereich ist der Nutzdatenbereich NB, der den weitaus größten Teil der Tabelle einnimmt. Darauf folgt der Bufferblockbereich BB mit einigen Zeigern auf Bufferblöcke. Der Reservebereich enthält Zeiger auf gelöschte Blöcke, die als Ersatz bereit stehen. Der Defektbereich zeigt nur auf defekte Blöcke.
Über eine logische Blockaderesse LBA wird auf die Zuordnertabelle ZT zugegriffen und dann für die Speicheroperation die dort verzeichnete Speicherblockadresse SBA genutzt. Die Speicherblöcke SB können Daten enthalten, können gelöscht ("erased") oder defekt ("defect") sein. Schreiboperationen auf einen Speicherblock SB laufen normalerweise über einen Bufferblock. Wird beim Schreiben erkannt, dass der Speicherblock defekt ist, wird der Merker DEF gesetzt und ein neuer Bufferblock aus dem Reservebereich genutzt.

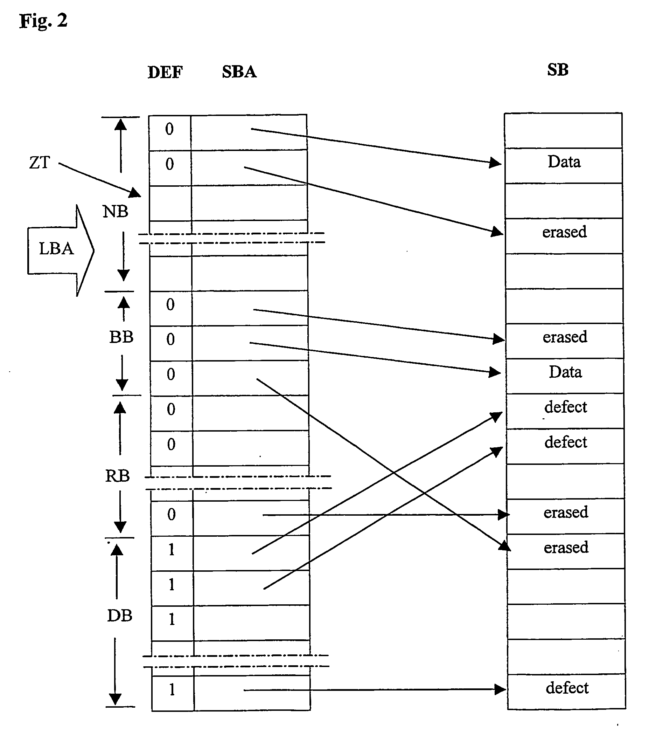

In Fig. 2 ist die Situation der Zuordnertabelle ZT nach dem Bereinigen des Schreibfehlers dargestellt. Der Bufferblockzeiger, der zuerst auf einen defekten Speicherblock SB zeigte, zeigt nun auf einen gelöschten Speicherblock, der bisher dem Reservebereich RB zugeordnet war. Der Reservebereich RB ist um einen Eintrag kürzer geworden und der Defektbereich DB ist um einen Eintrag länger geworden. Die Grenze zwischen beiden Bereichen ist um einen Eintrag verschoben. Die Gesamtsumme der den beiden Bereichen zugeordneten Blöcke ist konstant geblieben.

## Patentansprüche

1. Verfahren zur Verwaltung von defekten Speicherblöcken in einem nichtflüchtigen Speichersystem mit einzeln löschbaren, mit realen Speicherblockadressen (SBA) adressierbaren Speicherblöcken (SB), und die durch eine Adressumsetzung mittels einer Zuordnertabelle (ZT) von logischen Blockadressen (LBA) in jeweils eine der realen Speicherblockadressen (SBA) adressierbar sind, **dadurch gekennzeichnet, dass** die Zuordnertabelle (ZT) mindestens in einen Nutzdatenbereich (NB), einen Bufferblockbereich (BB), einen Defektbereich (DB) und in einen Reservebereich (RB) gegliedert ist, und dass nach einem Fehler beim Löschen eines Blockes die Zuordnertabelle (ZT) so geändert wird, dass die Speicherblockadresse des entsprechenden Blockes in den Defektbereich (DB) eingetragen und an seiner Stelle ein Block adressiert wird, der zuvor im Reservebereich (RB) eingetragen war.

2. Verfahren nach Anspruch 1, **dadurch gekennzeichnet, dass** der Defektbereich (DB) jeweils so viele Einträge enthält, wie defekte Blöcke vorhanden sind.

3. Verfahren nach Anspruch 2, **dadurch gekennzeichnet, dass** der Defektbereich (DB) durch das Eintragen eines defekten Blockes um einen Eintrag vergrößert und der Reservebereich (RB) um einen Eintrag verkleinert wird.

4. Verfahren nach Anspruch 3, **dadurch gekennzeichnet, dass** die Güte des Speichers durch das Verhältnis der Anzahl der Einträge des Reservebereichs (RB) zu denen des Defektbereichs (DB) bestimmt wird.

5. Verfahren nach Anspruch 1, **dadurch gekennzeichnet, dass** nach Fehlern beim Schreiben in einen Speicherblock (SB) der entsprechende Block mit dem Merker "defect" **gekennzeichnet** wird.

6. Verfahren nach Anspruch 5, **dadurch gekennzeichnet, dass** ein Hintergrundprogramm die Zuordnertabelle (ZT) nach zu löschenden Speicherblöcken (SB) durchsucht und diese löscht, falls aber ein solcher Speicherblock mit dem Merker "defect" versehen ist, diesen nicht löscht, sondern in den Defektbereich (DB) einträgt.

## Claims

1. Method for the management of defective memory blocks in a non volatile memory system with individually erasable memory blocks (SB), addressable with real memory block addresses (SBA), and which are addressable with an address conversion by means of a allocator table (ZT) of logical block addresses (LBA) into one of the real memory block addresses (SBA), **characterized in that** the allocator table (ZT) is divided into a useful data area (NB), a buffer block area (BB), a defect area (DB) and a reserve area (RB), and that after an error with the erasure of a block the allocator table (ZT) is changed **in that** way that the memory block address of the corresponding memory block is registered into the defect area (DB) and at its place a block is addressed, which was previously registered in the reserve area (RB).

2. Method according to claim 1, by the fact **characterized** that the defect area (DB) contains in each case so much entries, as defective blocks are present.

3. Method according to claim 2, **characterized in that** the defect area (DB) is increased by one entry on registering a defective block and the reserve area (RB) is reduced by one entry.

4. Method according to claim 3, **characterized in that** the quality of the memory is determined by the relationship of the number of the entries of the reserve area (RB) to the defect area (DB).

5. Method according to claim 1, **characterized in that** after errors during the write operation into a memory block (SB) the corresponding block is marked by the flag "defect" (DEF).

6. Method according to claim 5, **characterized in that** a background program scans the allocator table (ZT) for memory blocks (SB), which can be erased, and does erase these, but if such a memory block is marked with the flag "defect", does not erase this, but registers it into the defect area (DB).

## Revendications

1. Méthode pour la gestion des blocs de mémoire défectueux dans un système de mémoire non-volatile avec des blocs de mémoire (SB) séparément effaçables, accessibles par des adresses de bloc de mémoire réelles (SBA), et qui sont accessibles par une translation d'adresses au moyen d'une table de distributeur (ZT) qui change des adresses de bloc logiques (LBA), dans chaque cas à une des adresses de bloc de mémoire réelles (SBA), **caractérisée en ce que** la table de distributeur (ZT) est divisée en au moins un secteur des données utiles (NB), un secteur de bloc de mémoire tampon (BB), un secteur de défaut (DB) et un secteur de réserve (RB), et qu' après une erreur pendant l'effacement d'un bloc, la table de distributeur (ZT) est changée de telle façon que l'adresse de bloc de mémoire du bloc de mémoire correspondant est enregistré dans le secteur de défaut (DB) et à sa place un bloc est adressé, qui était précédemment enregistré dans le secteur de réserve (RB).

2. Méthode selon la revendication 1, **caractérisée en ce que** le secteur de défaut (DB) contient toujours le même nombre des entrées qu'existent des blocs défectueux.

3. Méthode selon la revendication 2, **caractérisée en ce que** le secteur de défaut (DB) est augmenté d'une entrée par l'enregistrement d'un bloc défectueux et le secteur de réserve (RB) est réduit d'une entrée.

4. Méthode selon la revendication 3, **caractérisée en ce que** la qualité de la mémoire est déterminée par la relation quantitative entre les entrées dans le secteur de réserve (RB) et celles dans le secteur de défaut (DB).

5. Méthode selon la revendication 1, **caractérisée en ce qu'**après des erreurs pendant l'opération d'inscription dans un bloc de mémoire (SB) le bloc correspondant est marqué par le drapeau « defect ».

6. Méthode selon la revendication 5, **caractérisée en ce qu'**un programme de fond fouille la table de distributeur (ZT) à la recherche des blocs de mémoire (SB), qui peuvent être effacés, et efface ces derniers, mais si un tel bloc de mémoire est marqué par le drapeau « défect », il n'efface pas celui-ci, mais l'enregistre dans le secteur de défaut (DB).
